# EUROPEAN PATENT APPLICATION

(11) **EP 4 598 318 A1**
(43) Date of publication of application: **06.08.2025**
(21) Application number: 25152959.0
(22) Date of filing: 20.01.2025
(51) Int. Cl.: H10K 59/12, H10K 59/122, H10K 59/80

(54) **DISPLAY DEVICE AND METHOD OF FABRICATING THE SAME**

(30) Priority: 01.02.2024 KR 20240015609
(71) Applicant: Samsung Display Co., Ltd., Yongin-si, Gyeonggi-do 17113 (KR)
(72) Inventor: SHIN, Hyun Eok, 17113 Yongin-si (KR); PARK, Jong Hee, 17113 Yongin-si (KR); LEE, Ju Hyun, 17113 Yongin-si (KR)
(74) Representative: Taor, Simon Edward William

(57) **Abstract**

A display device includes: a substrate including a light emitting area and a non-light emitting area; an anode electrode on the light emitting area of the substrate; a pixel defining layer on the non-light emitting area of the substrate and defining a first opening; a first auxiliary electrode on the pixel defining layer; a light emitting layer on the anode electrode and spaced apart from the first auxiliary electrode; a cathode electrode on the light emitting layer and the first auxiliary electrode; a cathode capping layer on the cathode electrode; a spacer on the cathode capping layer and defining a second opening; and a second auxiliary electrode on the cathode capping layer and the spacer.

## Description

### CROSS-REFERENCE TO RELATED APPLICATION

The present application claims priority to and the benefit of Korean Patent Application No. 10-2024-0015609, filed on February 01, 2024, in the Korean Intellectual Property Office.

### BACKGROUND

### 1. Field

Aspects of some embodiments of the present disclosure relate to a display device and a method of fabricating the same.

### 2. Description of the Related Art

As an information society develops, consumer demand for display devices for displaying images is increasing in various forms. For example, the display device has been applied to various electronic devices such as smartphones, digital cameras, laptop computers, navigation devices, and smart televisions. Display devices include, for example, flat panel display devices such as liquid crystal display devices, field emission display devices, or organic light emitting display devices. Among the flat panel display devices, the light emitting display device may include a light emitting element in which each of the pixels of a display panel may emit light by itself, thereby displaying images without a backlight unit providing the light to the display panel.

As various electronic devices have recently developed, consumer demand for high-resolution display devices is increasing. Because the high-resolution display devices require high pixel integration, the spacing between light emitting elements overlapping each light emitting area may be narrowed. Accordingly, the high-resolution display device may be formed by a pattern process of forming individual pixels rather than a mask process.

The above information disclosed in this Background section is only for enhancement of understanding of the background and therefore the information discussed in this Background section does not necessarily constitute prior art.

### SUMMARY

Aspects of some embodiments of the present disclosure include a display device that lowers resistance of a cathode electrode and solves a disconnection defect of the cathode electrode when forming a plurality of light emitting layers by a photo lithography method.

However, aspects of embodiments according to the present disclosure are not restricted to those set forth herein. The above and other aspects of embodiments according to the present disclosure will become more apparent to one of ordinary skill in the art to which the present disclosure pertains by referencing the detailed description of the present disclosure given below.

Details of other embodiments are included in the detailed description and drawings.

According to one or more embodiments of the present disclosure, a display device includes a substrate including a light emitting area and a non-light emitting area; an anode electrode on the light emitting area of the substrate; a pixel defining layer positioned on the non-light emitting area of the substrate and defining a first opening; a first auxiliary electrode positioned on the pixel defining layer; a light emitting layer positioned on the anode electrode and spaced apart from the first auxiliary electrode; a cathode electrode positioned on the light emitting layer and the first auxiliary electrode; a cathode capping layer positioned on the cathode electrode; a spacer positioned on the cathode capping layer and defining a second opening; and a second auxiliary electrode positioned on the cathode capping layer and the spacer.

According to some embodiments, the spacer may include a first spacer and a second spacer, in a portion overlapping the non-light emitting area, and the first spacer and the second spacer are spaced apart from each other in a direction parallel to the substrate with the first auxiliary electrode interposed therebetween.

According to some embodiments, the pixel defining layer may include a first surface facing the first auxiliary electrode, and the first surface includes: a first portion in contact with the first auxiliary electrode; a second portion that is in contact with the cathode electrode and overlaps the first spacer in a direction perpendicular to the substrate; and a third portion that is in contact with the cathode electrode and overlaps the second spacer in the direction perpendicular to the substrate.

According to some embodiments, the first portion may be positioned between the second portion and the third portion.

According to some embodiments, the first surface further may include a fourth portion in contact with the light emitting layer, and the fourth portion is spaced apart from the first portion.

According to some embodiments, the first auxiliary electrode may be entirely surrounded by the cathode electrode and the pixel defining layer.

According to some embodiments, the first auxiliary electrode may include a metal with lower resistance than the cathode electrode.

According to some embodiments, the cathode capping layer may be in contact with the second auxiliary electrode and the spacer, in a portion overlapping the non-light emitting area.

According to some embodiments, the second auxiliary electrode may include a first portion in contact with the cathode capping layer and a second portion in contact with the spacer, in a portion overlapping the non-light emitting area.

According to some embodiments, the second auxiliary electrode may be electrically connected to the first auxiliary electrode by the cathode capping layer and the cathode electrode in a portion overlapping the non-light emitting area.

According to some embodiments, the cathode capping layer and the second auxiliary electrode may include transparent conducting oxide.

According to some embodiments, the spacer may be entirely surrounded by the cathode capping layer and the second auxiliary electrode.

According to some embodiments, the light emitting layer may include a side surface facing the first auxiliary electrode, and an inclination angle formed between the pixel defining layer and the side surface is 60 degrees or more and 90 degrees or less.

According to some embodiments, the spacer may entirely surround the first auxiliary electrode in a portion overlapping the non-light emitting area in a plan view.

According to some embodiments, the second auxiliary electrode may entirely cover the spacer and the first auxiliary electrode in a portion overlapping the non-light emitting area in a plan view.

According to some embodiments, the first opening may be completely surrounded by the second opening in a plan view.

According to one or more embodiments of the disclosure, a method of fabricating a display device, the method includes forming an anode electrode on a substrate, forming a light emitting layer and a sacrificial layer on the anode electrode, and then removing a portion of the light emitting layer and the sacrificial layer; forming a first auxiliary electrode on the sacrificial layer and then removing a portion of the first auxiliary electrode so that the first auxiliary electrode is spaced apart from the light emitting layer in a direction parallel to the substrate; forming a cathode electrode and a cathode capping layer on the light emitting layer and the first auxiliary electrode, and forming a plurality of spacers on the cathode capping layer to planarize a level difference between the light emitting layer and the first auxiliary electrode; and forming a second auxiliary electrode on the plurality of spacers and the cathode capping layer, wherein in the forming of the second auxiliary electrode, the second auxiliary electrode is electrically connected to the first auxiliary electrode by the cathode capping layer and the cathode electrode.

According to some embodiments, in the forming of the light emitting layer, the light emitting layer may be formed by a photo lithography process.

According to some embodiments, in the forming of the spacers, the spacer may include hexamethyl disiloxane.

According to some embodiments, the forming of the first auxiliary electrode may include removing the sacrificial layer and exposing the light emitting layer through an etching process.

According to some embodiments, the display device may lower the resistance of the cathode electrode by including the first auxiliary electrode arranged to be spaced apart between the plurality of light emitting layers, when forming the plurality of light emitting layers using the photo lithography method. In addition, the display device according to some embodiments may solve contact defects caused by disconnection of the cathode electrode by including a spacer that flattens a level difference between the first auxiliary electrode and the plurality of pixels and a second auxiliary electrode that covers the first auxiliary electrode and the spacer.

According to an aspect, there is provided a display device as set out in claim 1. Additional features are set out in claims 2 to 13. According to an aspect, there is provided a method as set out in claim 14. Additional features are set out in claim 15.

However, the characteristics of embodiments according to the present disclosure are not restricted to those set forth herein. The above and other characteristics of the embodiments will become more apparent to one of ordinary skill in the art to which the embodiments pertain by referencing the claims.

### BRIEF DESCRIPTION OF THE DRAWINGS

The above and other aspects and features of embodiments of the present disclosure will become more apparent by describing in detail embodiments thereof with reference to the attached drawings, in which:
FIG. 1 is a perspective view illustrating an electronic device according to some embodiments;
FIG. 2 is a perspective view illustrating a display device included in the electronic device according to some embodiments ;
FIG. 3 is a schematic cross-sectional view of the display device of FIG. 2 according to some embodiments;
FIG. 4 is a plan view illustrating an arrangement of light emitting areas in a display area of FIG. 3 according to some embodiments;
FIG. 5 is a schematic cross-sectional view of the display area taken along line X1-X1' of FIG. 4 according to some embodiments;
FIG. 6 is a schematic enlarged cross-sectional view of a light emitting element of FIG. 5 according to some embodiments;
FIG. 7 is a schematic enlarged cross-sectional view of a first light emitting area of FIG. 5 according to some embodiments;
FIG. 8 is a schematic enlarged cross-sectional view of a non-light emitting area located between a first light emitting area and a second light emitting area of FIG. 5 according to some embodiments;
FIG. 9 is a plan view illustrating a first auxiliary electrode, a spacer, and a second auxiliary electrode overlapping a non-light emitting area in FIG. 8 according to some embodiments; and
FIGS. 10 to 22 are cross-sectional views illustrating a method of fabricating a display element layer and a thin film encapsulation layer in FIG. 5 according to some embodiments.

### DETAILED DESCRIPTION

Aspects of some embodiments of the present disclosure will now be described more fully herein with reference to the accompanying drawings, in which some embodiments of the invention are shown. The invention may, however, be embodied in different forms and should not be construed as limited to the embodiments set forth herein. Rather, these embodiments are provided so that this disclosure will be thorough and complete, and will fully convey the scope of the invention to those skilled in the art.

It is also to be understood that when a layer is referred to as being "on" another layer or substrate, it may be directly on the other layer or substrate, or one or more intervening layers may also be present. The same reference numbers indicate the same components throughout the specification.

It is to be understood that, although the terms "first," "second," etc. may be used herein to describe various elements, these elements should not be limited by these terms. These terms are used to distinguish one element from another element. For instance, a first element discussed below could be termed a second element without departing from the teachings of the invention. Similarly, the second element could also be termed a first element.

Unless otherwise defined, all terms (including technical and scientific terms) used herein have the same meaning as commonly understood by one of ordinary skill in the art to which the inventive concept pertains. It is also to be understood that terms defined in commonly used dictionaries should be interpreted as having meanings consistent with the meanings in the context of the related art, and are expressly defined herein unless they are interpreted in an ideal or overly formal sense.

Hereinafter, embodiments of the present disclosure will be described in more detail with reference to the accompanying drawings.

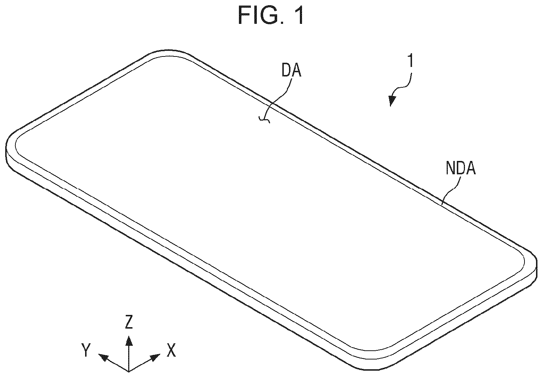

FIG. 1 is a schematic perspective view of an electronic device 1 according to some embodiments.

Referring to FIG. 1, an electronic device 1 displays a moving image (e.g., video images) or a still image (e.g., static images). The electronic device 1 may refer to any electronic device that provides a display screen. For example, electronic device 1 may include televisions, laptop computers, monitors, billboards, Internet of things, mobile phones, smartphones, tablet personal computers (PCs), electronic watches, smartwatches, watch phones, head mounted displays, mobile communication terminals, electronic notebooks, electronic books, portable multimedia players (PMPs), navigation, game consoles, digital cameras, camcorders, and the like that provide the display screen.

In FIG. 1, a first direction (X-axis direction), a second direction (Y-axis direction), and a third direction (Z-axis direction) are defined. The first direction (X-axis direction) and the second direction (Y-axis direction) may be perpendicular to each other, the first direction (X-axis direction) and the third direction (Z-axis direction) may be perpendicular to each other, and the second direction (Y-axis direction) and the third direction (Z-axis direction) may be perpendicular to each other. It may be understood that the first direction (X-axis direction) means a horizontal direction in the drawings, the second direction (Y-axis direction) means a vertical direction in the drawings, and the third direction (Z-axis direction) means upper and lower directions in the drawings, that is, a thickness direction. In the following specification, unless otherwise specified, the term "direction" may refer to both directions toward both sides extending along the direction. In addition, when both "directions" extending to both sides need to be distinguished from each other, one side will be referred to as "one side in the direction" and the other side will be referred to as "the other side in the direction". In FIG. 1, a direction in which an arrow indicating a direction is directed is referred to as one side, and an opposite direction thereof is referred to as the other side.

Hereinafter, for convenience of explanation, in referring to surfaces of the electronic device 1 or each member constituting the electronic device 1, one surface facing one side in a direction in which an image is displayed, that is, in the third direction (Z-axis direction) is referred to as an upper surface, and an opposite surface of the one surface is referred to as the other surface. However, the present disclosure is not limited thereto, and the one surface and the other surface of the member may be referred to as a front surface and a rear surface, respectively, or may also be referred to as a first surface or a second surface. In addition, in describing a relative position of each member of the electronic device 1, one side in the third direction (Z-axis direction) may be referred to as an upper side and the other side in the third direction (Z-axis direction) may be referred to as a lower side.

A shape of the electronic device 1 may be variously changed. For example, the electronic device 1 may have a shape such as a rectangle with a long width, a rectangle with a long length, a square, a quadrangle with rounded corners (vertices), other polygons, or a circle.

The electronic device 1 may include a display area DA and a non-display area NDA. The display area DA is an area at which images may be displayed, and the non-display area NDA is an area at which images are not displayed. The display area DA may also be referred to as an active area, and the non-display area NDA may also be referred to as a non-active area. The display area DA may generally occupy the center of the electronic device 1.

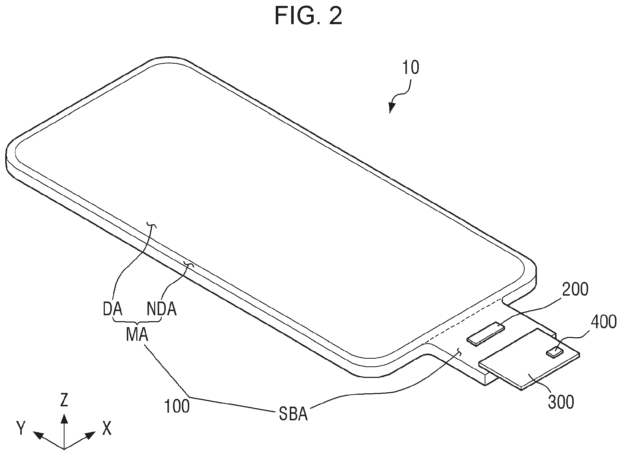

FIG. 2 is a perspective view illustrating a display device 10 included in the electronic device 1 according to some embodiments.

Referring to FIG. 2, the electronic device 1 according to some embodiments may include a display device 10. The display device 10 may provide a screen displayed by the electronic device 1. Examples of the display device 10 may include an inorganic light emitting diode display device, an organic light emitting display device, a quantum dot light emitting display device, a plasma display device, and a field emission display device. Hereinafter, it is illustrated that an organic light emitting diode display device is used as an example of the display device, but embodiments according to the present disclosure are not limited thereto and may also be applied to other display devices as long as the same technical idea is applicable thereto.

The display device 10 may have a planar shape similar to that of the electronic device 1. For example, the display device 10 may have a shape similar to a rectangle having a short side in a first direction (X-axis direction) and a long side in a second direction (Y-axis direction). A corner where the short side in the first direction (X-axis direction) and the long side in the second direction (Y-axis direction) meet may be rounded to have a curvature, but is not limited thereto and may also be formed at a right angle. The planar shape of the display device 10 is not limited to the quadrangle, and may be formed similarly to other polygons, circles, or ovals.

The display device 10 may include a display panel 100, a display driver 200, a circuit board 300, and a touch driver 400.

The display panel 100 may include a main area MA and a sub-area SBA. The main area MA may include a display area DA including pixels displaying an image, and a non-display area NDA arranged around (e.g., in a periphery or outside a footprint of) the display area DA.

The display area DA may emit light from a plurality of light emitting areas or a plurality of openings to be described in more detail later. For example, the display panel 100 may include a pixel circuit including switching elements, a pixel defining layer defining the light emitting areas or the openings, and a self-light emitting element. For example, the self-light emitting element may include, but is not limited to, at least one of an organic light emitting diode (LED) including an organic light emitting layer, a quantum dot LED including a quantum dot light emitting layer, an inorganic LED including an inorganic semiconductor, or a micro LED. In the following drawings, it is illustrated that the self-light emitting element is an organic light emitting diode.

The non-display area NDA may be an area outside the display area DA. The non-display area NDA may be defined as an edge area of the main area MA of the display panel 100.

The sub-area SBA may be an area extending from one side of the main area MA. The sub-area SBA may include a flexible material that may be bent, folded, rolled, or the like. For example, when the sub-area SBA is bent, the sub-area SBA may overlap the main area MA in a thickness direction (e.g., a third direction (Z-axis direction)). The sub-area SBA may include the display driver 200 and a pad portion connected to the circuit board 300. According to some embodiments, the sub-area SBA may be omitted, and the display driver 200 and the pad portion may be positioned in the non-display area NDA.

The display driver 200 may output signals and voltages for driving the display panel 100. The display driver 200 may be formed as an integrated circuit (IC) and mounted on the display panel 100 by a chip on glass (COG) method, a chip on plastic (COP) method, or an ultrasonic bonding method. For example, the display driver 200 may be located in the sub-area SBA, and may overlap the main area MA in the thickness direction by bending of the sub-area SBA. As another example, the display driver 200 may be mounted on the circuit board 300.

The circuit board 300 may be attached onto the pad portion of the display panel 100 using an anisotropic conductive film (ACF). The circuit board 300 may be a flexible film such as a flexible printed circuit board, a printed circuit board, or a chip on film.

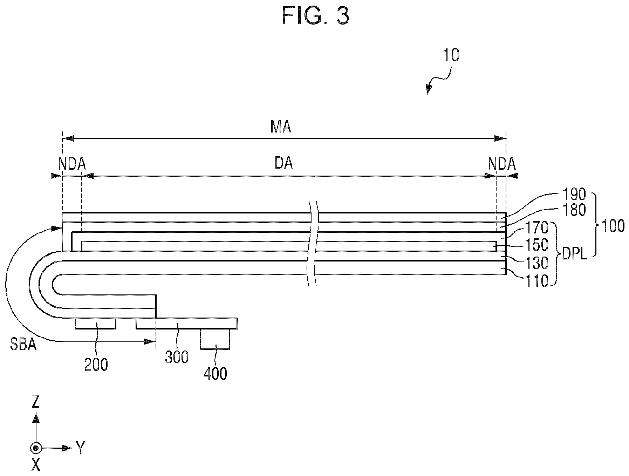

The touch driver 400 may be mounted on the circuit board 300. The touch driver 400 may be connected to a touch sensor layer (element "180" in FIG. 3) of the display panel 100. The touch driver 400 may be formed as an integrated circuit.

FIG. 3 is a schematic cross-sectional view of the display device 10 of FIG. 2.

Referring to FIG. 3, the display panel 100 may include a display layer DPL, a touch sensor layer 180, and a color filter layer 190. The display layer DPL may include a substrate 110, a thin film transistor layer 130, a display element layer 150, and a thin film encapsulation layer 170.

The substrate 110 may be a base substrate or a base member. The substrate 110 may be a flexible substrate that may be bent, folded, rolled, or the like. For example, the substrate 110 may include a polymer resin such as polyimide PI, but is not limited thereto. According to some embodiments, the substrate 110 may include a glass material or a metal material.

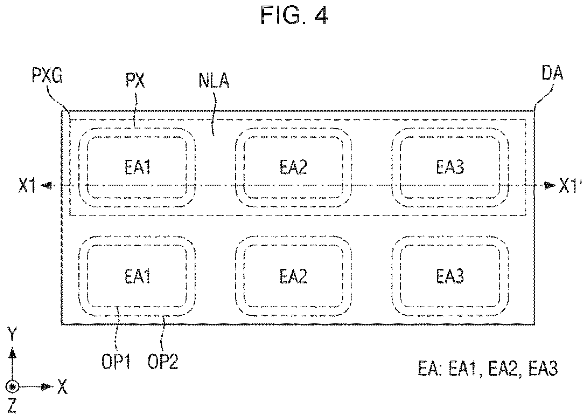

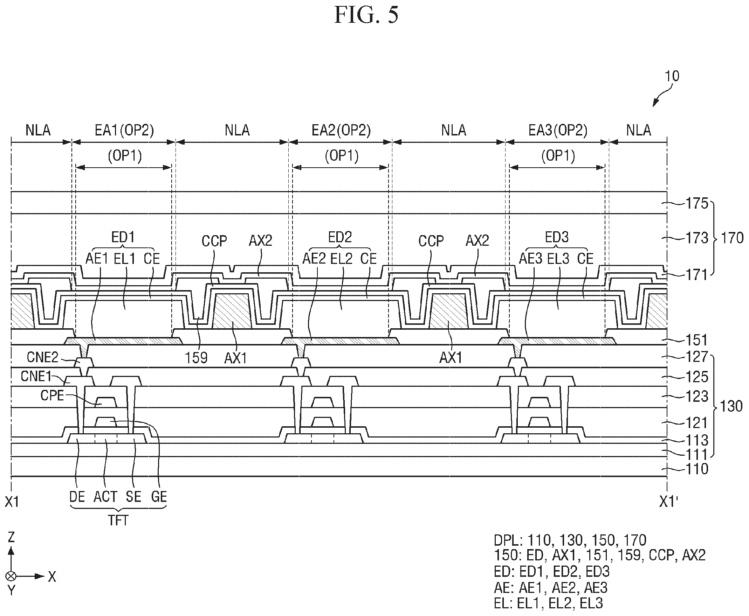

The thin film transistor layer 130 may be positioned on the substrate 110. The thin film transistor layer 130 may be positioned in the display area DA, the non-display area NDA, and the sub-area SBA. The thin film transistor layer 130 may include a plurality of thin film transistors (TFT in FIG. 5) constituting a pixel (PX in FIG. 4).

The display element layer 150 may be positioned on the thin film transistor layer 130. The display element layer 150 may be positioned to overlap the display area DA. The display element layer 150 may include a plurality of light emitting elements (ED in FIG. 5). As an example, the display element according to some embodiments may include, but is not limited to, at least one of an organic light emitting diode (LED) including an organic light emitting layer, a quantum dot LED including a quantum dot light emitting layer, an inorganic LED including an inorganic semiconductor, or a micro LED.

The thin film encapsulation layer 170 may be positioned on the display element layer 150. The thin film encapsulation layer 170 may be positioned to overlap the display area DA and the non-display area NDA. The thin film encapsulation layer 170 may cover an upper surface and side surfaces of the display element layer 150, and may protect the display element layer 150 from external oxygen and moisture.

The touch sensor layer 180 may be positioned on the thin film encapsulation layer 170. The touch sensor layer 180 may be positioned to overlap the display area DA and the non-display area NDA. The touch sensor layer 180 may sense a user's touch in a mutual capacitance method or a self-capacitance method.

The color filter layer 190 may be positioned on the touch sensor layer 180. The color filter layer 190 may be positioned to overlap the display area DA and the non-display area NDA. The color filter layer 190 may absorb a portion of light introduced from the outside of the display device 10 to reduce reflected light caused by external light. Therefore, the color filter layer 190 may prevent color distortion caused by reflection of external light.

As the color filter layer 190 is directly located on the touch sensor layer 180, the display device 10 may not require a separate substrate for the color filter layer 190. Therefore, the display device 10 may have a relatively small thickness. In addition, the color filter layer 190 may also be omitted according to some embodiments.

As illustrated in FIG. 3, a portion of the display layer DPL overlapping the sub-area SBA may be bent. When a portion of the display layer DPL is bent, the display driver 200, circuit board 300, and touch driver 400 may overlap the main area MA in the third direction (Z-axis direction).

FIG. 4 is a plan view illustrating an arrangement of light emitting areas EA in the display area DA of FIG. 3.

Referring to FIG. 4, the display area DA according to some embodiments may include a plurality of first to third light emitting areas EA1, EA2, and EA3 and a non-light emitting area NLA. The non-light emitting area NLA may be positioned to surround the plurality of first to third light emitting areas EA1, EA2, and EA3.

The non-light emitting area NLA may block each light emitted from the plurality of first to third light emitting areas EA1, EA2, and EA3. As a result, the non-light emitting area NLA may assist in preventing each light emitted from the first to third light emitting areas EA1, EA2, and EA3 from being mixed. A pixel defining layer (151 in FIG. 5) and a spacer (159 in FIG. 5), which will be described in more detail later, may be positioned in the non-light emitting area NLA.

The light emitting areas EA may include a first light emitting area EA1, a second light emitting area EA2, and a third light emitting area EA3 that emit light of different colors. Each of the first to third light emitting areas EA1, EA2, and EA3 may each emit red, green, or blue light, and the color of light emitted from each of the first to third light emitting areas EA1, EA2, and EA3 may vary depending on the type of light emitting element ED, which will be described in more detail later. According to some embodiments, the first light emitting area EA1 may emit red light of a first color, the second light emitting area EA2 may emit green light of a second color, and the third light emitting area EA3 may emit blue light of a third color, but embodiments according to the present disclosure are not limited thereto. It is illustrated in the drawing that the size and shape of each of the first to third light emitting areas EA1, EA2, and EA3 are the same, but embodiments according to the present disclosure are not limited thereto. The size and shape of each of the first to third light emitting areas EA1, EA2, and EA3 may be freely adjusted according to required characteristics.

The plurality of first to third light emitting areas EA1, EA2, and EA3 may be defined by a first opening OP1 and a second opening OP2. As an example, the first opening OP1 may be defined by a pixel defining layer 151, which will be described in more detail later, and the second opening OP2 may be defined by a spacer 159, which will be described in more detail later. In a plan view, the second opening OP2 may completely surround the first opening OP1, and the second opening OP2 may be completely surrounded by the non-light emitting area NLA.

According to some embodiments, at least one first light emitting area EA1, at least one second light emitting area EA2, and at least one third light emitting area EA3 arranged to be adjacent to each other may form one pixel group PXG. The pixel group PXG may be a minimum unit that emits white light. However, the type and/or number of the first to third light emitting areas EA1, EA2, and EA3 constituting the pixel group PXG may vary depending on the embodiments.

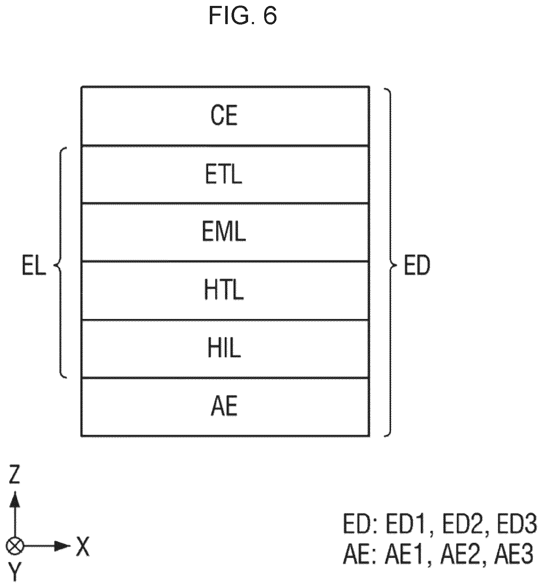

FIG. 5 is a schematic cross-sectional view of the display area DA taken along line X1-X1' of FIG. 4. FIG. 5 is a partial cross-sectional view of the display device 10 overlapping the display area DA and illustrates a schematic cross-section of the display layer DPL. That is, FIG. 5 illustrates a cross section of the substrate 110, the thin film transistor layer 130, the display element layer 150, and the thin film encapsulation layer 170 of the display device 10. Because the substrate 110 has been described with reference to FIG. 3, the description thereof will be omitted. FIG. 6 is an enlarged schematic cross-sectional view of the light emitting element ED of FIG. 5.

Referring to FIG. 5, the thin film transistor layer 130 may be positioned on the substrate 110. The thin film transistor layer 130 may include a first buffer layer 111, a thin film transistor TFT, a gate insulating layer 113, a first interlayer insulating layer 121, a capacitor electrode CPE, a second interlayer insulating layer 123, a first connection electrode CNE1, a first via layer 125, a second connection electrode CNE2, and a second via layer 127.

The first buffer layer 111 may be positioned on the substrate 110. The first buffer layer 111 may include an inorganic film capable of preventing permeation of air or moisture. For example, the first buffer layer 111 may include a plurality of inorganic films alternately stacked.

The thin film transistor TFT may be located on the first buffer layer 111, and may constitute a pixel circuit connected to each of the plurality of pixels. As an example, the thin film transistor TFT may be a driving transistor or a switching transistor of the pixel circuit. The thin film transistor TFT may include an active layer ACT, a source electrode SE, a drain electrode DE, and a gate electrode GE.

The active layer ACT may be positioned on the first buffer layer 111. The active layer ACT may overlap the gate electrode GE in the third direction (Z-axis direction), and may be insulated from the gate electrode GE by the gate insulating layer 113. In a portion of the active layer ACT, a material of the active layer ACT may become a conductor to form the source electrode SE and the drain electrode DE.

The gate electrode GE may be positioned on the gate insulating layer 113. The gate electrode GE may overlap the active layer ACT with the gate insulating layer 113 interposed therebetween.

The gate insulating layer 113 may be positioned on the active layer ACT. The gate insulating layer 113 may cover the active layer ACT and the first buffer layer 111, and may insulate the active layer ACT and the gate electrode GE from each other. The gate insulating layer 113 may include a contact hole through which the first connection electrode CNE1 penetrates.

The first interlayer insulating layer 121 may cover the gate electrode GE and the gate insulating layer 113. The first interlayer insulating layer 121 may include a contact hole through which the first connection electrode CNE1 penetrates. The contact hole of the first interlayer insulating layer 121 may be connected to the contact hole of the gate insulating layer 113 and a contact hole of the second interlayer insulating layer 123.

The capacitor electrode CPE may be positioned on the first interlayer insulating layer 121. The capacitor electrode CPE may overlap the gate electrode GE in the third direction (Z-axis direction). The capacitor electrode CPE and the gate electrode GE may form a capacitance.

The second interlayer insulating layer 123 may cover the capacitor electrode CPE and the first interlayer insulating layer 121. The second interlayer insulating layer 123 may include a contact hole through which the first connection electrode CNE1 penetrates. The contact hole of the second interlayer insulating layer 123 may be connected to the contact hole of the first interlayer insulating layer 121 and the contact hole of the gate insulating layer 113.

The first connection electrode CNE1 may be positioned on the second interlayer insulating layer 123. The first connection electrode CNE1 may electrically connect the drain electrode DE of the thin film transistor TFT and the second connection electrode CNE2 to each other. The first connection electrode CNE1 may be inserted into the contact holes formed in the first interlayer insulating layer 121, the second interlayer insulating layer 123, and the gate insulating layer 113 and be in contact with the drain electrode DE of the thin film transistor TFT.

The first via layer 125 may cover the first connection electrode CNE1 and the second interlayer insulating layer 123. The first via layer 125 may planarize a lower structure. The first via layer 125 may include a contact hole through which the second connection electrode CNE2 penetrates.

The second connection electrode CNE2 may be positioned on the first via layer 125. The second connection electrode CNE2 may be inserted into the contact hole formed in the first via layer 125 and be in contact with the first connection electrode CNE1. The second connection electrode CNE2 may electrically connect the first connection electrode CNE1 and first to third anode electrodes AE1, AE2, and AE3 to each other.

The second via layer 127 may cover the second connection electrode CNE2 and the first via layer 125. The second via layer 127 may include a contact hole through which the first to third anode electrodes AE1, AE2, and AE3 penetrate.

The display element layer 150 may be positioned on the second via layer 127. The display element layer 150 may include a light emitting element ED, a first auxiliary electrode AX1, a pixel defining layer 151, a spacer 159, a cathode capping layer CCP, and a second auxiliary electrode AX2.

The pixel defining layer 151 according to some embodiments may be located on the second via layer 127 in a portion overlapping the non-light emitting area NLA. The pixel defining layer 151 may cover a portion of the anode electrode AE in a portion overlapping each of the first to third light emitting areas EA1, EA2, and EA3. The pixel defining layer 151 may separate and insulate the first to third anode electrodes AE1, AE2, and AE3 from each other. As described above, the pixel defining layer 151 may define the first opening OP1.

The pixel defining layer 151 may include an inorganic insulating material. As an example, the pixel defining layer 151 may include aluminum oxide, titanium oxide, tantalum oxide, hafnium oxide, zinc oxide, silicon oxide, silicon nitride, and silicon oxynitride.

The first auxiliary electrode AX1 according to some embodiments may be positioned on the pixel defining layer 151 in a portion overlapping the non-light emitting area NLA. The first auxiliary electrode AX1 may be positioned to be spaced apart from the plurality of light emitting layers EL in the first direction (X-axis direction). The first auxiliary electrode AX1 may assist in lowering resistance of the cathode electrode CE.

The light emitting element ED according to some embodiments may include an anode electrode AE, a light emitting layer EL, and a cathode electrode CE. The light emitting element ED may include a first light emitting element ED1 located in the first light emitting area EA1, a second light emitting element ED2 located in the second light emitting area EA2, and a third light emitting element ED3 located in the third light emitting area EA3.

The light emitting elements ED overlapping each of the first to third light emitting areas EA1, EA2, and EA3 may emit light of different colors depending on the material of the light emitting layer EL. For example, the first light emitting element ED1 may emit red light of a first color, the second light emitting element ED2 may emit green light of a second color, and the third light emitting element ED3 may emit blue light of a third color.

The anode electrode AE according to some embodiments may be positioned on the second via layer 127. The anode electrode AE may be electrically connected to the drain electrode DE of the thin film transistor TFT through the first and second connection electrodes CNE1 and CNE2.

The anode electrode AE may include a first anode electrode AE1 located in the first light emitting area EA1, a second anode electrode AE2 located in the second light emitting area EA2, and a third anode electrode AE3 located in the third light emitting area EA3. The first anode electrode AE1, the second anode electrode AE2, and the third anode electrode AE3 may be positioned to be spaced apart from each other on the second via layer 127.

The anode electrode AE may have a stacked film structure in which a material layer having a high work function, made of indium tin oxide (ITO), indium zinc oxide (IZO), zinc oxide (ZnO), or indium oxide (In₂O₃) and a reflective material layer made of silver (Ag), magnesium (Mg), aluminum (Al), platinum (Pt), lead (Pd), palladium (Pd), gold (Au), nickel (Ni), neodymium (Nd), iridium (Ir), chromium (Cr), lithium (Li), calcium (Ca), or mixtures thereof are stacked. As an example, the anode electrode AE may have a multilayer structure of ITO/Mg, ITO/MgF, ITO/Ag, and ITO/Ag/ITO, but embodiments according to the present disclosure are not limited thereto.

The light emitting layer EL according to some embodiments may be located on the anode electrode AE. The light emitting layer EL may include a first light emitting layer EL1, a second light emitting layer EL2, and a third light emitting layer EL3 located in the first to third light emitting areas EA1, EA2, and EA3, respectively. The first light emitting layer EL1, the second light emitting layer EL2, and the third light emitting layer EL3 may emit light of different colors depending on the material included in an organic light emitting layer EML, which will be described in more detail later. As an example, the first light emitting layer EL1 may emit red light of a first color, the second light emitting layer EL2 may emit green light of a second color, and the third light emitting layer EL3 may emit blue light of a third color, but embodiments according to the present disclosure are not limited thereto. The first to third light emitting layers EL1, EL2, and EL3 may be spaced apart in the first direction (X-axis direction) with a first auxiliary electrode AX1 and a spacer 159, which will be described in more detail later, interposed therebetween.

The light emitting layer EL according to some embodiments may be formed through a photo lithography process during the fabricating process. The fabricating process will be described in more detail later.

Referring to FIG. 6, the light emitting layer EL according to some embodiments may include a hole injection layer HIL, a hole transporting layer HTL, an organic light emitting layer EML, and an electron transporting layer ETL. According to some embodiments, the hole injection layer HIL and the hole transporting layer HTL may be formed as one layer to form a hole injection and transporting layer.

The hole injection layer HIL may have a single layer made of a single material, a single layer made of a plurality of different materials, or a multilayer structure having a plurality of layers each made of different materials. As an example, the hole injection layer HIL may include, but is not limited to, a phthalocyanine compound such as copper phthalocyanine, DNTPD(N,N'-diphenylN,N'-bis-[4-(phenyl-m-tolyl-amino)-phenyl]-biphenyl-4,4'-diamine), m-MTDATA(4,4',4"-tris(3methylphenylphenylamino)triphenylamine), TDATA(4,4'4"-Tris(N,N-diphenylamino)triphenylamine), 2TNATA(4,4',4"-tris{N,-(2-naphthyl)-N-phenylamino}-triphenylamine), PEDOT/PSS(Poly(3,4- ethylenedioxythiophene)/Poly(4-styrenesulfonate)), PANI/DBSA(Polyaniline/Dodecylbenzenesulfonic acid), PANI/CSA(Polyaniline/Camphor sulfonicacid), PANI/PSS((Polyaniline)/Poly(4-styrenesulfonate)), etc.

The hole transporting layer HTL may have a single layer made of a single material, a single layer made of a plurality of different materials, or a multilayer structure having a plurality of layers each made of different materials. As an example, the hole transporting layer HTL may include, but is not limited to, carbazole-based derivatives such as N-phenylcarbazole and polyvinylcarbazole; fluorene-based derivatives, triphenylamine-based derivatives such as TPD(N,N'-bis(3-methylphenyl)-N,N'-diphenyl-[1,1-biphenyl]-4,4'-diamine), TCTA(4,4',4"-tris(Ncarbazolyl)triphenylamine), or the like, NPB(N,N'-di(1-naphthyl)-N,N'-diphenylbenzidine), TAPC(4,4'-Cyclohexylidene bis[N,N-bis(4-methylphenyl)benzenamine]), or the like.

The organic light emitting layer EML may include a host material and a dopant material. The host material is not particularly limited as long as it is a commonly used material, but, for example, Alq3(tris(8-hydroxyquinolino)aluminum), CBP(4,4'-bis(N-carbazolyl)-1,1 '-biphenyl), PVK(poly(n-vinylcabazole)), ADN(9,10-di(naphthalene-2-yl)anthracene), TCTA(4,4',4"-Tris(carbazol-9-yl)-triphenylamine), TPBi(1,3,5-tris(N-phenylbenzimidazole-2-yl)benzene), TBADN(3-tert-butyl-9,10-di(naphth-2-yl)anthracene), DSA(distyrylarylene), CDBP(4,4'-bis(9-carbazolyl)-2,2"-dimethylbiphenyl), MADN(2-Methyl-9,10-bis(naphthalen-2-yl)anthracene), etc. may be used.

As an example, when the organic light emitting layer EML emits red light, the organic light emitting layer EML may include a fluorescent material including perylene or PBD:Eu(DBM)3(Phen)(tris(dibenzoylmethanato)phenanthoroline europium). In this case, the included dopant material may be selected from, for example, a metal complex or an organometallic complex such as PIQIr(acac)(bis(1-phenylisoquinoline)acetylacetonate iridium), PQIr(acac)(bis(1-phenylquinoline)acetylacetonateiridium), PQIr(tris(1-phenylquinoline)iridium), and PtOEP(octaethylporphyrin platinum).

As an example, when the organic light emitting layer EML emits green light, the organic light emitting layer EML may include a fluorescent material including tris(8-hydroxyquinolino)aluminum (Alq3). In this case, the included dopant material may be selected from, for example, a metal complex or an organometallic complex such as Ir(ppy)3(fac-tris(2-phenylpyridine)iridium).

As an example, when the organic light emitting layer EML emits blue light, the organic light emitting layer EML may include a fluorescent material including any one selected from the group consisting of spiro-DPVBi, spiro-6P, distyryl-benzene (DSB), distyryl-arylene (DSA), polyfluorene (PFO)-based polymers, and poly(p-phenylene vinylene) (PPV)-based polymers. In this case, the included dopant material may be selected from, for example, a metal complex or an organometallic complex such as (4,6-F2ppy)2Irpic. However, the materials included in the organic light emitting layer EML are only examples and are not limited thereto.

The electron transporting layer ETL may be located on the organic light emitting layer EML. The electron transporting layer ETL may serve to inject and transport electrons transferred from the cathode electrode CE to the light emitting layer EL. As an example, the electron transporting layer ETL may include an electron transport material such as Alq3(Tris(8-hydroxyquinolinato)aluminum), TPBi(1,3,5-Tri(1-phenyl-1H-benzo[d]imidazol-2-yl)phenyl), BCP(2,9-Dimethyl-4,7-diphenyl-1,10-phenanthroline), Bphen(4,7-Diphenyl-1,10-phenanthroline), TAZ(3-(4-Biphenylyl)-4-phenyl-5-tert-butylphenyl-1,2,4-triazole), NTAZ(4-(Naphthalen-1-yl)-3,5-diphenyl-4H-1,2,4-triazole), tBu-PBD(2-(4-Biphenylyl)-5-(4-tert-butylphenyl)-1,3,4-oxadiazole), BAIq(Bis(2-methyl-8-quinolinolato-N1,O8)-(1,1'-Biphenyl-4-olato)aluminum), Bebq2(berylliumbis(benzoquinolin-10-olate), ADN(9,10-di(naphthalene-2-yl)anthracene), and a mixture thereof, and lanthanide metals such as LiF, LiQ (Lithium quinolate), Li₂O, BaO, NaCl, CsF, Yb, or halogenated metals such as RbCl and Rbl, but is not limited thereto.

Referring to FIGS. 5 and 6, the cathode electrode CE may be located on the electron transporting layer ETL. The cathode electrode CE according to some embodiments may be a common electrode arranged to overlap the first to third light emitting areas EA1, EA2, and EA3 and the non-light emitting area NLA.

The cathode electrode CE may receive a common voltage or a low potential voltage. Specifically, when the anode electrode AE receives a voltage corresponding to the data voltage and the cathode electrode CE receives the low potential voltage, holes and electrons may each move to the organic light emitting layer EML through the hole transporting layer HTL, the hole injection layer HIL, and the electron transporting layer ETL, and the moved holes and electrons may be bonded to each other in the organic light emitting layer EML to emit light. That is, as a potential difference is formed between the anode electrode AE and the cathode electrode CE, the light emitting layer EL may emit light.

The cathode capping layer CCP may be positioned on the cathode electrode CE. The cathode capping layer CCP according to some embodiments may be a common layer arranged to overlap the first to third light emitting areas EA1, EA2, and EA3 and the non-light emitting area NLA. The cathode capping layer CCP may entirely cover the cathode electrode CE.

The spacer 159 according to some embodiments may be positioned on the cathode capping layer CCP in a portion overlapping the non-light emitting area NLA. The spacer 159 according to some embodiments may be formed in plural in a portion overlapping the non-light emitting area NLA. The spacer 159 may be positioned in a spaced portion between the light emitting layer EL and the first auxiliary electrode AX1. The spacer 159 may planarize a level difference between the light emitting layer EL and the first auxiliary electrode AX1. The spacer 159 may define a second opening OP2.

The second auxiliary electrode AX2 according to some embodiments may be positioned on the cathode capping layer CCP and the spacer 159. The second auxiliary electrode AX2 may be a common layer positioned in a portion overlapping the first to third light emitting areas EA1, EA2, and EA3 and the non-light emitting area NLA.

The second auxiliary electrode AX2 may assist in stably electrically connecting the cathode electrode CE and the cathode capping layer CCP positioned to overlap the light emitting area EA. In addition, the second auxiliary electrode AX2 may assist in stably electrically connecting the first auxiliary electrode AX1, the cathode electrode CE, and the cathode capping layer CCP positioned to overlap the non-light emitting area NLA.

The thin film encapsulation layer 170 may be positioned on the display element layer 150. The thin film encapsulation layer 170 may be located in a portion overlapping the first to third light emitting areas EA1, EA2, and EA3 and the non-light emitting area NLA. The thin film encapsulation layer 170 may include a first encapsulation layer 171, a second encapsulation layer 173, and a third encapsulation layer 175 that are sequentially stacked.

The first encapsulation layer 171 may be positioned on the second auxiliary electrode AX2. The first encapsulation layer 171 may include one or more inorganic insulating materials and may prevent oxygen or moisture from permeating into the light emitting element ED. As an example, the first encapsulation layer 171 may include any one of aluminum oxide, titanium oxide, tantalum oxide, hafnium oxide, zinc oxide, silicon oxide, silicon nitride, and silicon oxy nitride.

The second encapsulation layer 173 may be positioned on the first encapsulation layer 171. The second encapsulation layer 173 may protect the display element layer 150 from foreign substances. The second encapsulation layer 173 may include a polymer-based material. As an example, the second encapsulation layer 173 may include a silicon-based resin, an acrylic-based resin, an epoxy-based resin, and a mixture thereof.

The third encapsulation layer 175 may be positioned on the second encapsulation layer 173. The third encapsulation layer 175 may include one or more inorganic insulating materials and may prevent oxygen or moisture from permeating into the display element layer 150 and the first encapsulation layer 171. The third encapsulation layer 175 may include the same material as the first encapsulation layer 171. The redundant descriptions will be omitted.

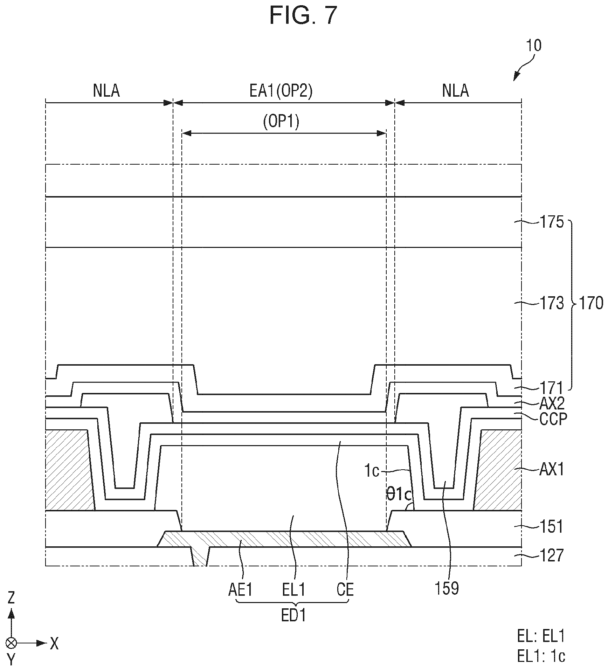

FIG. 7 is an enlarged schematic cross-sectional view of the first light emitting area EA1 of FIG. 5.

Referring to FIG. 7, the pixel defining layer 151 may be positioned on the second via layer 127 and the anode electrode AE. The pixel defining layer 151 may expose the first anode electrode AE1 at a portion overlapping the first opening OP1. The pixel defining layer 151 may cover an edge of the first anode electrode AE1.

According to some embodiments, the first light emitting layer EL1 may include a side surface 1c facing the first auxiliary electrode AX1. The side surface 1c of the first light emitting layer EL1 may be an inclined surface. In other words, the side surface 1c of the first light emitting layer EL1 may be inclined between the first direction (X-axis direction) and the third direction (Z-axis direction). As described above, in the display device 10 according to some embodiments, the light emitting layer EL may be formed through the photo lithography process. Because the photo lithography process forms the light emitting layer EL through a photo process and an etching process without a separate mask, the first light emitting layer EL1 may have a clear side surface 1c without tail defects caused by mask shadows.

The side surface 1c of the first light emitting layer EL1 according to some embodiments may have a high taper angle. As an example, an inclination angle θ1c formed between the side surface 1c of the first light emitting layer EL1 and the pixel defining layer 151 may range from 60 degrees or more to 90 degrees or less.

The first auxiliary electrode AX1 according to some embodiments may be spaced apart from the light emitting layer EL in the first direction (X-axis direction). In other words, the first auxiliary electrode AX1 may be spaced apart from the first light emitting layer EL1 in the first direction (X-axis direction) with the spacer 159 interposed therebetween.

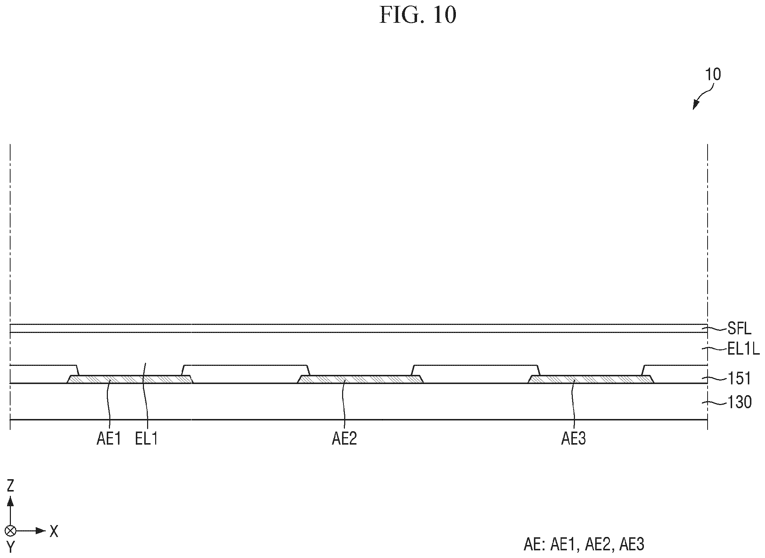

The first auxiliary electrode AX1 according to some embodiments may include a metal that has excellent contact characteristics with the cathode electrode CE and has lower resistance than the cathode electrode CE. In addition, the first auxiliary electrode AX1 may include a metal having an etch selectivity with a sacrificial layer (SFL in FIG. 10), which will be described in more detail later. As an example, the first auxiliary electrode AX1 may include any one of aluminum/titanium, molybdenum, copper/titanium, and indium-titanium-oxide/silver/indium-titanium-oxide. The fabricating process will be described in more detail later.

The cathode electrode CE according to some embodiments may entirely cover the first light emitting layer EL1 in a portion overlapping the first light emitting area EA1. In addition, the cathode electrode CE may entirely cover the pixel defining layer 151 and the first auxiliary electrode AX1 in a portion overlapping the non-light emitting area NLA. The cathode electrode CE according to some embodiments may have a level difference in a portion overlapping the non-light emitting area NLA.

The cathode electrode CE according to some embodiments may include a metal with high electrical conductivity. As an example, the cathode electrode CE may include a material layer having a small work function, such as Li, Ca, LiF/Ca, LiF/Al, Al, Mg, Ag, Pt, Pd, Ni, Au, Nd, Ir, Cr, BaF, Ba, or a compound or mixture thereof (e.g., a mixture of Ag and Mg, etc.).

The cathode capping layer CCP according to some embodiments may be positioned between the cathode electrode CE and the second auxiliary electrode AX2 in the third direction (Z-axis direction) in a portion overlapping the first light emitting area EA1, and may be positioned between the cathode electrode CE and the spacer 159 in the third direction (Z-axis direction) in a portion overlapping the non-light emitting area NLA. The cathode capping layer CCP may have a level difference in a portion overlapping the non-light emitting area NLA.

The cathode capping layer CCP may serve to protect the cathode electrode CE from an etchant used in the etching process when forming the spacer 159 in the process of fabricating the display device 10. The fabricating process will be described in more detail later.

The cathode capping layer CCP may include transparent conducting oxide (TCO). As an example, the cathode capping layer CCP may include indium-tin-oxide (ITO), indium-zinc-oxide (IZO), zinc-indium-tin-oxide (ZITO), and the like.

The spacer 159 according to some embodiments may be positioned between the cathode capping layer CCP and the second auxiliary electrode AX2 in the third direction (Z-axis direction) in a portion overlapping the non-light emitting area NLA. The spacer 159 may be entirely surrounded by the cathode capping layer CCP and the second auxiliary electrode AX2.

The spacer 159 may fill the level difference formed between the light emitting layer EL and the first auxiliary electrode AX1. In other words, the spacer 159 may planarize the level difference formed between the light emitting layer EL and the first auxiliary electrode AX1.

The spacer 159 may include a fluid insulating material. As an example, the spacer 159 may be hexamethyl disiloxane (HMDSO).

The second auxiliary electrode AX2 according to some embodiments may be positioned between the cathode capping layer CCP and the first encapsulation layer 171 in the third direction (Z-axis direction) in a portion overlapping the first light emitting area EA1. In addition, the second auxiliary electrode AX2 may also be positioned between the spacer 159 and the first encapsulation layer 171 in the third direction (Z-axis direction) in a portion overlapping the non-light emitting area NLA.

As the display device 10 according to some embodiments includes the spacer 159 between the light emitting layer EL and the first auxiliary electrode AX1, the second auxiliary electrode AX2 may be stably connected without being disconnected due to the level difference between the light emitting layer EL and the first auxiliary electrode AX1.

The second auxiliary electrode AX2 may include transparent conducting oxide (TCO). As an example, the cathode capping layer CCP may include indium-tin-oxide (ITO), indium-zinc-oxide (IZO), zinc-indium-tin-oxide (ZITO), and the like.

The first encapsulation layer 171 according to some embodiments may be formed to have the same thickness along a profile of a lower structure in a portion overlapping the first light emitting area EA1. Therefore, the first encapsulation layer 171 may have a level difference. The level difference included in the first encapsulation layer 171 may be planarized by the second encapsulation layer 173. As a result, the third encapsulation layer 175 according to some embodiments may be formed without having a level difference. Other redundant descriptions will be omitted.

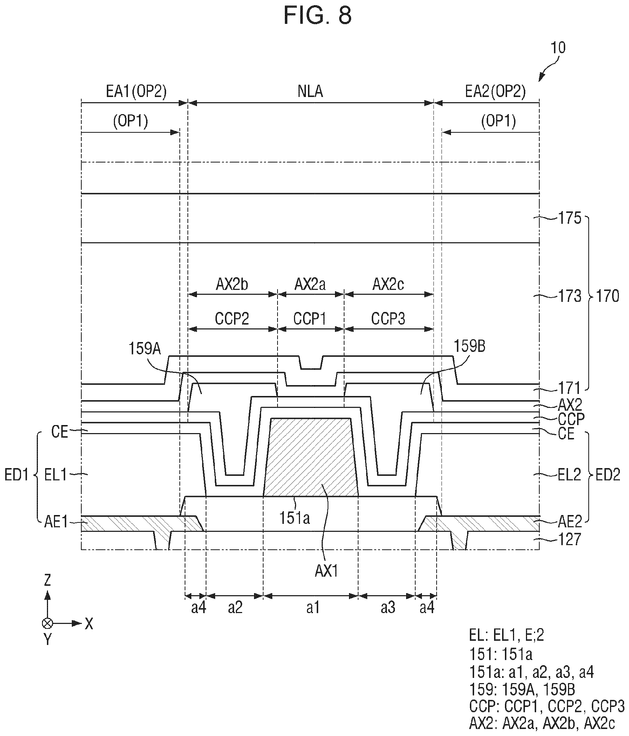

FIG. 8 is an enlarged schematic cross-sectional view of the non-light emitting area NLA positioned between the first light emitting area EA1 and the second light emitting area EA2 of FIG. 5.

Referring to FIG. 8, the spacer 159 according to some embodiments may include a first spacer 159A and a second spacer 159B. The first spacer 159A and the second spacer 159B may be spaced apart from each other in the first direction (X-axis direction) with the first auxiliary electrode AX1 interposed therebetween. The first spacer 159A and the second spacer 159B may be formed integrally during the process of fabricating the display device 10 and then formed separately in the form illustrated through a subsequent etching process. That is, the first spacer 159A and the second spacer 159B may have the same material.

The first spacer 159A may be positioned toward the first light emitting area EA1, and the second spacer 159B may be positioned towards the second light emitting area EA2. In other words, the first spacer 159A may be positioned to overlap the first light emitting element ED1 in the third direction (Z-axis direction), and the second spacer 159B may be positioned to overlap the second light emitting element ED2 in the third direction (Z-axis direction).

The pixel defining layer 151 according to some embodiments may be positioned on the second via layer 127, the first anode electrode AE1, and the second anode electrode AE2.

According to some embodiments, the pixel defining layer 151 may include a first surface 151a facing the first auxiliary electrode AX1. The first surface 151a of the pixel defining layer 151 may have a first portion a1, a second portion a2, a third portion a3, and a fourth portion a4, depending on a structure in contact therewith. Specifically, the first portion a1 may be a portion in contact with the first auxiliary electrode AX1, the second portion a2 and the third portion a3 may be portions in contact with the cathode electrode CE, and the fourth portion a4 may be a portion in contact with the light emitting layer EL. In addition, the second portion a2 may be a portion overlapping the first spacer 159A in the third direction (Z-axis direction), and the third portion a3 may be a portion overlapping the second spacer 159B. The first portion a1 may be positioned between the second portion a2 and the third portion a3.

The cathode electrode CE according to some embodiments may be in contact with the light emitting layer EL, the pixel defining layer 151, and the first auxiliary electrode AX1 in a portion overlapping the non-light emitting area NLA.

According to some embodiments, the cathode capping layer CCP may include a first portion CCP1, a second portion CCP2, and a third portion CCP3 depending on a structure in contact therewith in a portion overlapping the non-light emitting area NLA. The first portion CCP1 may be a portion in contact with the second auxiliary electrode AX2, the second portion CCP2 may be a portion in contact with the first spacer 159A, and the third portion CCP3 may be a portion in contact with the second spacer 159B. The first portion CCP1 may be positioned between the second portion CCP2 and the third portion CCP3.

According to some embodiments, the second auxiliary electrode AX2 may include a first portion AX2a, a second portion AX2b, and a third portion AX2c depending on a structure in contact therewith in a portion overlapping the non-light emitting area NLA. The first portion AX2a may be a portion in contact with the cathode capping layer CCP, the second portion AX2b may be a portion in contact with the first spacer 159A, and the third portion AX2c may be a portion in contact with the second spacer 159B. The first portion AX2a may be positioned between the second portion AX2b and the third portion AX2c.

The first encapsulation layer 171 according to some embodiments may be formed to have the same thickness along a profile of a lower structure in a portion overlapping the non-light emitting area NLA. Therefore, the first encapsulation layer 171 may have a level difference. The level difference included in the first encapsulation layer 171 may be planarized by the second encapsulation layer 173. As a result, the third encapsulation layer 175 according to some embodiments may be formed without having a level difference. Other redundant descriptions will be omitted.

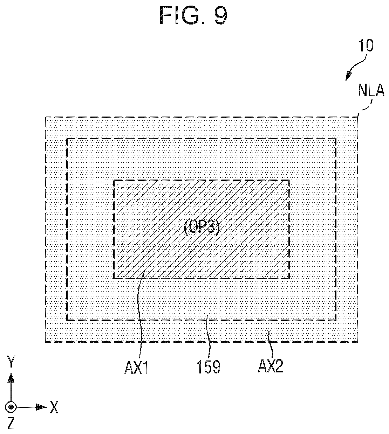

FIG. 9 is a plan view illustrating a first auxiliary electrode AX1, a spacer 159, and a second auxiliary electrode AX2 positioned to overlap a non-light emitting area NLA in FIG. 8.

Referring to FIG. 9, in a plan view, in a portion overlapping the non-light emitting area NLA, the spacer 159 may expose a portion of the first auxiliary electrode AX1 and may completely surround the first auxiliary electrode AX1. In other words, in a plan view, in a portion overlapping the non-light emitting area NLA, the spacer 159 may define a third opening OP3, and in a plan view, the spacer 159 may expose the first auxiliary electrode AX1 in a portion overlapping the third opening OP3.

In addition, in a plan view, in a portion overlapping the non-light emitting area NLA, the second auxiliary electrode AX2 may entirely cover the spacer 159 and the first auxiliary electrode AX1.

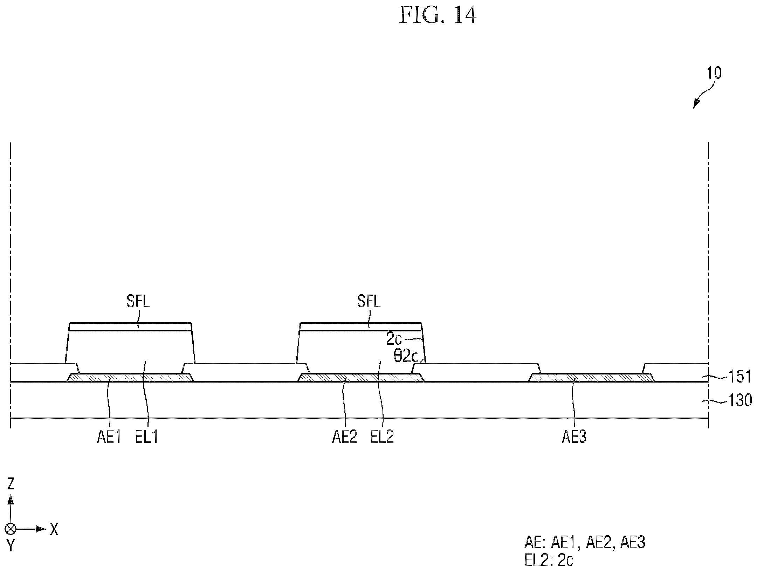

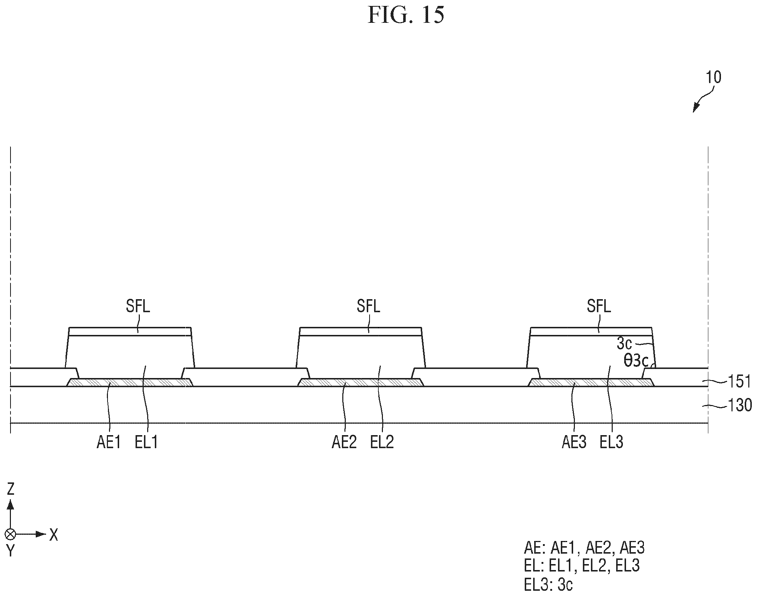

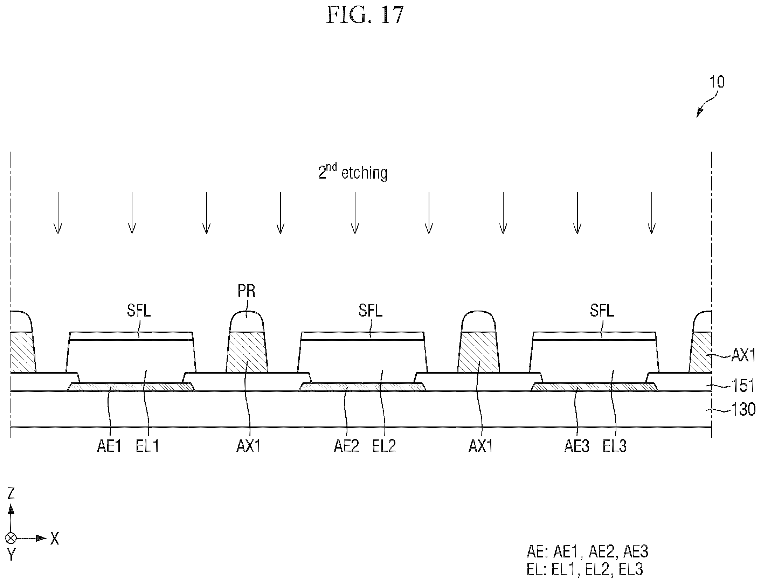

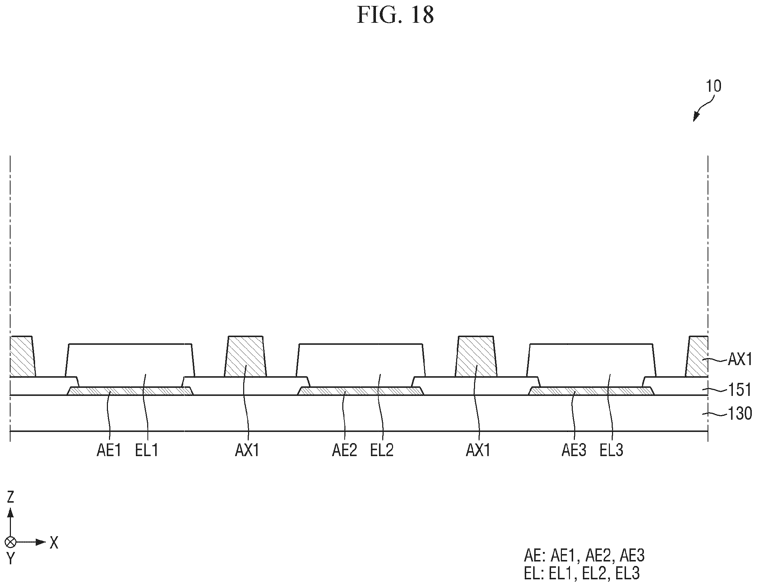

FIGS. 10 to 22 are cross-sectional views illustrating a method of fabricating the display element layer 150 and the thin film encapsulation layer 170 in FIG. 5. Hereinafter, the order of forming each layer of the display element layer 150 and the thin film encapsulation layer 170 will be described.

Referring to FIG. 10, an anode electrode AE and a pixel defining layer 151 are formed on the thin film transistor layer 130. The anode electrode AE may include first to third anode electrodes AE1, AE2, and AE3. According to some embodiments, the thin film transistor layer 130 may be located on the substrate 110, and a structure of the thin film transistor layer 130 is the same as that described above with reference to FIG. 5.

A pixel defining layer 151 may be located between the plurality of anode electrodes AE. The pixel defining layer 151 may cover an edge of the anode electrode AE. The pixel defining layer 151 may separate and insulate the first to third anode electrodes AE1, AE2, and AE3 from each other.

Next, a first light emitting material layer EL1L is formed on the anode electrode AE and the pixel defining layer 151. The first light emitting material layer EL1L may entirely cover the anode electrode AE and the pixel defining layer 151.

Next, a sacrificial layer SFL is formed on the first light emitting material layer EL1L. The sacrificial layer SFL may protect the first light emitting material layer EL1L from an etchant when a subsequent etching process is performed. The above-described etchant may refer to liquid and gas used in an etching solution.

The sacrificial layer SFL may be formed directly on the first light emitting material layer EL1L and may include a metal material. As an example, the sacrificial layer SFL may include, but is not limited to, any one of aluminum (Al) and silver (Ag).

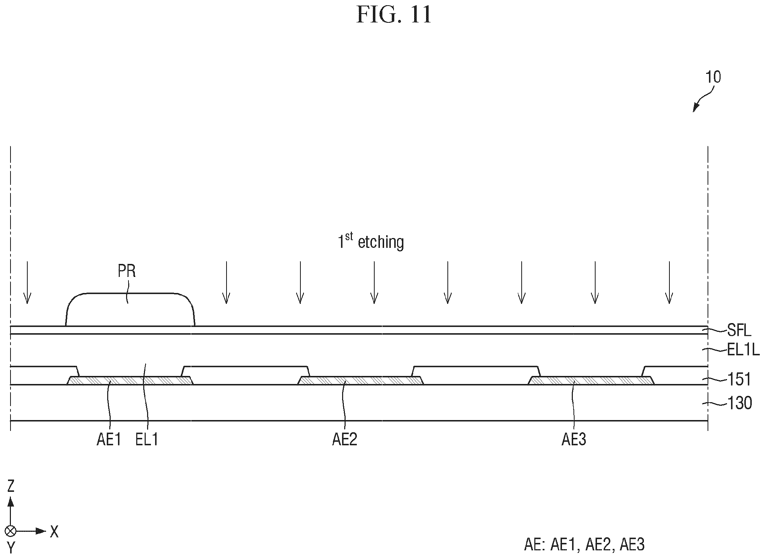

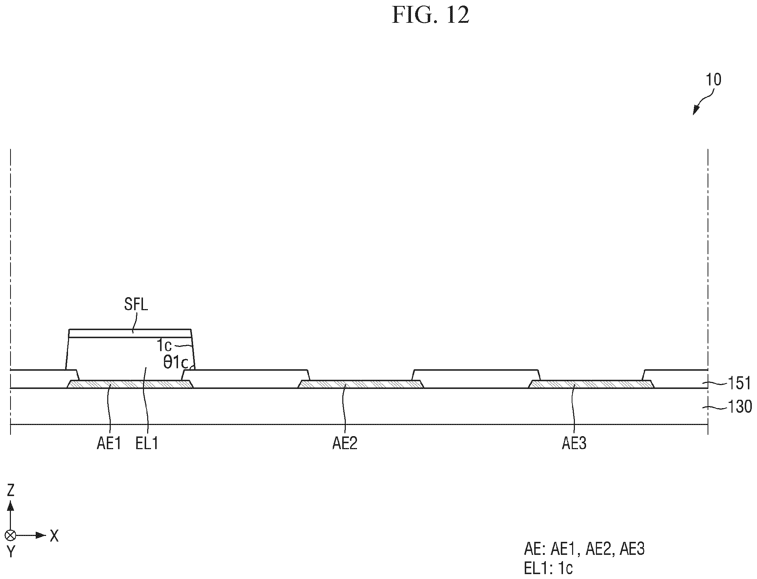

Next, referring to FIGS. 11 and 12, a photoresist PR is formed on the first anode electrode AE1, and a first etching process is performed using the photoresist PR as a mask. The photoresist PR may be positioned on the sacrificial layer SFL positioned to overlap the first anode electrode AE1. In the present process, a portion of the sacrificial layer SFL and a portion of the first light emitting material layer EL1L on which the photoresist PR is not formed may be removed. The first etching process may be performed as a single dry etching process or may be performed alternately as a dry etching process and a wet etching process.

In the present process, the first light emitting material layer EL1L may be formed as the first light emitting layer EL1, and the sacrificial layer SFL may be positioned on the first light emitting layer EL1. In the present process, the second anode electrode AE2 and the third anode electrode AE3 may be exposed again.

As the first light emitting layer EL1 according to some embodiments is formed through the first etching process without a separate fine metal mask, the first light emitting layer EL1 may include a clear side surface 1c without tail defects and mask shadow defects. In addition, a high taper angle may be formed between the side surface 1c of the first light emitting layer EL1 and the pixel defining layer 151. As an example, an inclination angle θ1c formed between the side surface 1c of the first light emitting layer EL1 and the pixel defining layer 151 may range from 60 degrees or more to 90 degrees or less. As a result, this may mean that the first light emitting layer EL1 according to some embodiments is formed through a photo lithography process.

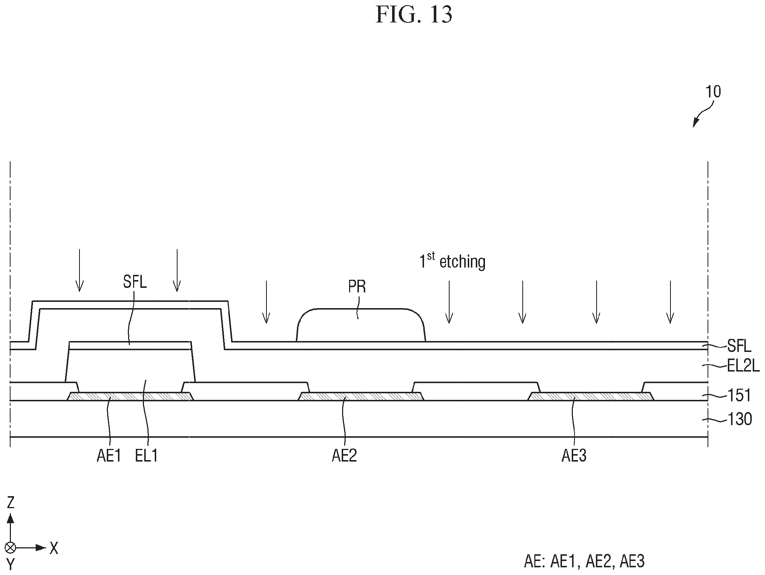

Next, referring to FIGS. 13 to 15, a second light emitting layer EL2 is formed by repeating the above-described process. Specifically, a second light emitting material layer EL2L and a sacrificial layer SFL are entirely formed on the first light emitting layer EL1, the pixel defining layer 151, the second anode electrode AE2, and the third anode electrode AE3. In the present process, the second light emitting material layer EL2L may cover along a profile of the first light emitting layer EL1.

Next, a photoresist PR is formed on the second anode electrode AE2, and the first etching process described above is performed. The photoresist PR may be positioned on the sacrificial layer SFL positioned to overlap the second anode electrode AE2. In the present process, a portion of the sacrificial layer SFL and the second light emitting material layer EL2L on which the photoresist PR is not formed may be removed.

In the present process, the second light emitting material layer EL2L may be formed as the second light emitting layer EL2, and the sacrificial layer SFL may be positioned on the second light emitting layer EL2. In addition, the third anode electrode AE3 may be exposed again.

In the present process, the second light emitting layer EL2 according to some embodiments may include a clear side surface 2c, and an inclination angle θ2c formed between the side surface 2c of the second light emitting layer EL2 and the pixel defining layer 151 may range from 60 degrees or more to 90 degrees or less. The redundant descriptions will be omitted.

Next, the third light emitting layer EL3 is formed by repeating the above-described process. In the present process, a sacrificial layer SFL may be positioned on the third light emitting layer EL3. The third light emitting layer EL3 according to some embodiments may include a clear side surface 3c, and an inclination angle θ3c formed between the side surface 3c of the third light emitting layer EL3 and the pixel defining layer 151 may range from 60 degrees or more to 90 degrees or less. The redundant descriptions will be omitted.

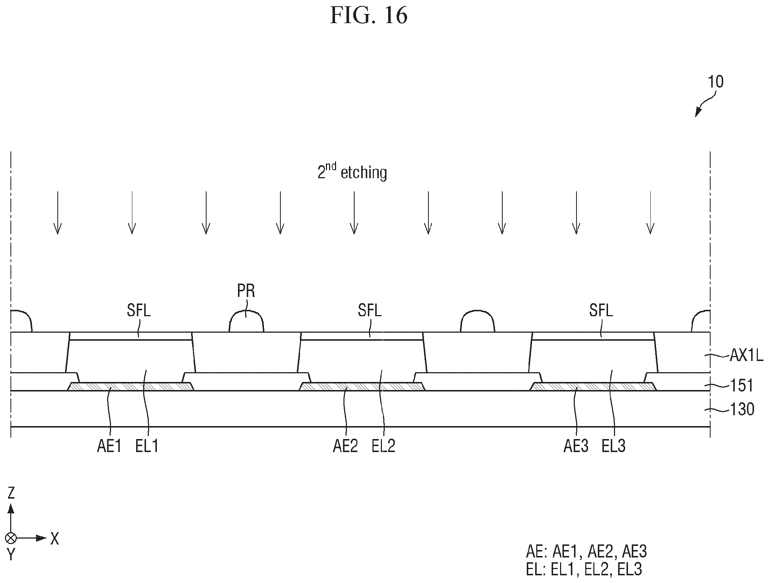

Next, referring to FIGS. 16 to 18, a first auxiliary electrode material layer AX1L is entirely formed on the light emitting layer EL and the pixel defining layer 151, and then a photoresist PR is formed in a portion overlapping the pixel defining layer 151. The photoresist PR may be positioned on the first auxiliary electrode material layer AX1L.

The first auxiliary electrode material layer AX1L may include a material having an etch selectivity different from that of the sacrificial layer SFL positioned on the light emitting layer EL. As an example, the first auxiliary electrode material layer AX1L may include any one of aluminum/titanium, molybdenum, copper/titanium, and indium-titanium-oxide/silver/indium-titanium-oxide.

Next, a second etching process is performed using the photoresist PR as a mask. In the second etching process, two steps may be sequentially performed.

First, a portion of the first auxiliary electrode material layer AX1L may be removed by performing either a dry etching process or a wet etching process. The type of etching process may be determined depending on the material included in the first auxiliary electrode material layer AX1L. As an example, when the first auxiliary electrode material layer AX1L includes either aluminum/titanium or molybdenum, the present process may be performed as a dry etching process, and when the first auxiliary electrode material layer AX1L includes any one of titanium/copper or indium-titanium-oxide/silver/indium-titanium-oxide, the present process may be performed as a wet etching process. A first auxiliary electrode AX1 may be formed through the first process. The first auxiliary electrodes AX1 may be formed to be spaced apart between the plurality of light emitting layers EL.

Second, the sacrificial layer SFL positioned on the light emitting layer EL may be removed by performing a wet etching process. The light emitting layer EL may be exposed through the present process.

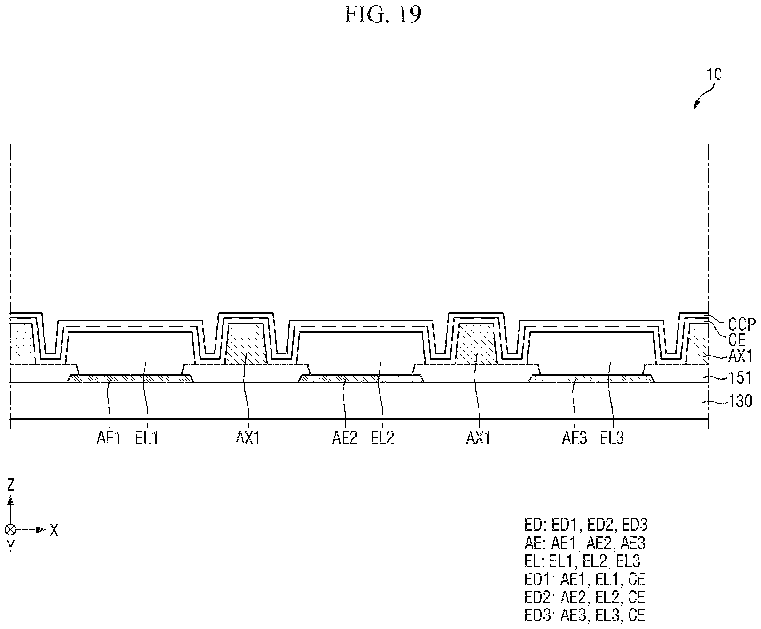

Next, referring to FIG. 19, a cathode electrode CE and a cathode capping layer CCP are entirely deposited on the light emitting layer EL and the first auxiliary electrode AX1. The cathode electrode CE may be formed by thermal deposition or sputtering deposition, and the cathode capping layer CCP may be formed by sputtering deposition. Redundant descriptions of materials included in the cathode electrode CE and cathode capping layer CCP will be omitted.

The cathode electrode CE may be entirely formed on the light emitting layer EL and the first auxiliary electrode AX1. As the cathode electrode CE is formed to be in contact with the first auxiliary electrode AX1, the cathode electrode CE and the first auxiliary electrode AX1 may be electrically connected. As described above, as the first auxiliary electrode AX1 according to some embodiments includes the metal material that has excellent contact characteristics with the cathode electrode CE and has lower resistance than the cathode electrode CE, the display device 10 according to some embodiments may lower the resistance of the cathode electrode CE.

The cathode capping layer CCP may be entirely formed on the cathode electrode CE. As the display device 10 according to some embodiments includes the cathode capping layer CCP on the cathode electrode CE, the cathode electrode CE may be protected from an etchant used in a third etching process, which will be described in more detail later. Accordingly, the display device 10 according to some embodiments may solve a disconnection defect of the cathode electrode CE that may occur during the process of fabricating the display device 10.

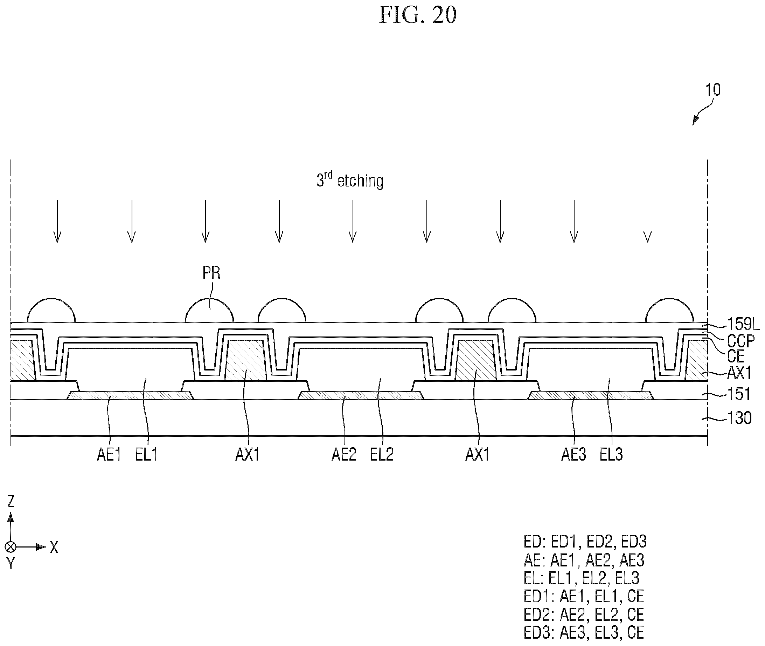

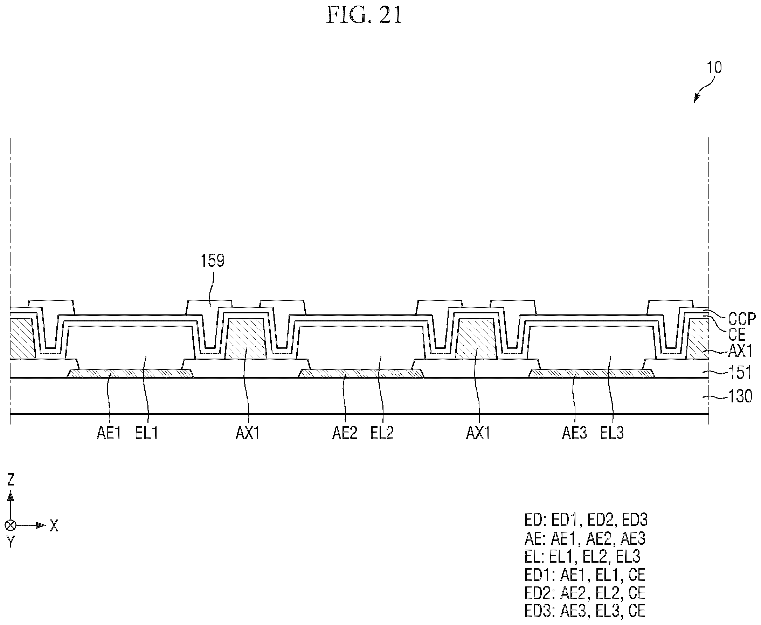

Referring to FIGS. 20 and 21, a spacer material layer 159L is formed on the cathode capping layer CCP. The spacer material layer 159L may be entirely formed. Next, a photoresist PR is formed in an overlapping portion between the light emitting layer EL and the first auxiliary electrode AX1, and then a third etching process is performed using a plurality of photoresists PR as a mask. As an example, the third etching process may be performed as a dry etching process. As described above, the spacer material layer 159L may include an inorganic insulating material.

In the present process, the spacer 159 of the type illustrated in FIG. 5 may be formed. The spacer may fill a spaced portion between the light emitting layer EL and the first auxiliary electrode AX1 and may planarize a level difference between the light emitting layer EL and the first auxiliary electrode AX1.

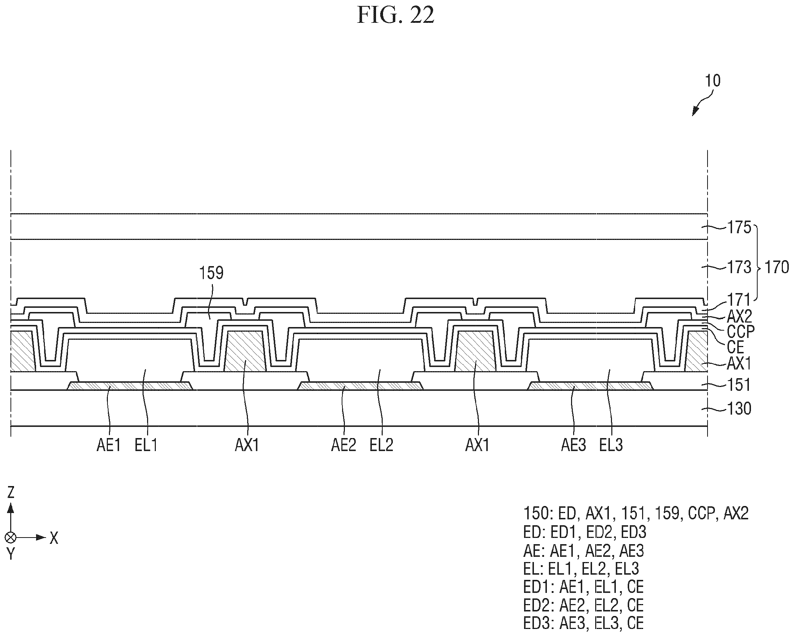

Finally, referring to FIG. 22, a second auxiliary electrode AX2 is entirely formed on the cathode capping layer CCP and the plurality of spacers 159. The second auxiliary electrode AX2 may be in contact with the cathode capping layer CCP in a portion overlapping the light emitting layer EL and the first auxiliary electrode AX1, and may be in contact with the spacer 159 in a portion overlapping the spacer 159. The second auxiliary electrode AX2 may assist in stably forming an electrical connection between the cathode electrode CE and the first auxiliary electrode AX1.

As the display device 10 according to some embodiments includes the plurality of spacers 159 that cover the level difference formed between the light emitting layer EL and the first auxiliary electrode AX1, it is possible to assist the second auxiliary electrode AX2 in being in contact with the cathode capping layer CCP without disconnection defects.

Next, the thin film encapsulation layer 170 illustrated in FIG. 5 is formed by forming a first encapsulation layer 171, a second encapsulation layer 173, and a third encapsulation layer 175 on the second auxiliary electrode AX2. The first encapsulation layer 171 and the third encapsulation layer 175 may be formed by a chemical vapor deposition method, and the second encapsulation layer 173 may be formed by an inkjet method. As a result, the display element layer 150 and the thin film encapsulation layer 170 included in the display device 10 according to some embodiments may be formed.

As discussed, embodiments may provide a display device comprising: a substrate including a light emitting area and a non-light emitting area; an anode electrode on the light emitting area of the substrate; a pixel defining layer on the non-light emitting area of the substrate and defining a first opening; a first auxiliary electrode on the pixel defining layer; a light emitting layer on the anode electrode and spaced apart from the first auxiliary electrode; a cathode electrode on the light emitting layer and the first auxiliary electrode; a cathode capping layer on the cathode electrode; a spacer on the cathode capping layer and defining a second opening; and a second auxiliary electrode on the cathode capping layer and the spacer.

The first auxiliary electrode may be positioned on the pixel defining layer in a portion overlapping a non-light emitting area. The first auxiliary electrode may be positioned to be spaced apart from the plurality of light emitting layers in a first direction.

The first auxiliary electrode may protrude away from the substrate in a second direction. For example, the first auxiliary electrode may have an island shape.

The cathode capping layer may be positioned on the cathode electrode. The cathode capping layer according to some embodiments may be a common layer arranged to overlap first to third light emitting areas and the non-light emitting area. The cathode capping layer may entirely cover the cathode electrode.

The spacer may be positioned on the cathode capping layer in a portion overlapping the non-light emitting area. The spacer may be formed in plural in a portion overlapping the non-light emitting area. The spacer may be positioned in a spaced portion between the light emitting layer and the first auxiliary electrode. The spacer may planarize a level difference between the light emitting layer and the first auxiliary electrode.

In a plan view, the second opening may completely surround the first opening, and the second opening may be completely surrounded by the non-light emitting area.

The second auxiliary electrode according to some embodiments may be positioned on the cathode capping layer and the spacer. The second auxiliary electrode may be a common layer positioned in a portion overlapping first to third light emitting areas and the non-light emitting area.

The spacer may include a first spacer and a second spacer. The first spacer and the second spacer may be spaced apart from each other in the first direction with the first auxiliary electrode interposed therebetween.

Embodiments may provide a method of fabricating a display device, the method comprising: forming an anode electrode on a substrate; forming a light emitting layer and a sacrificial layer on the anode electrode; removing a portion of the light emitting layer and the sacrificial layer; forming a first auxiliary electrode on the sacrificial layer and then removing a portion of the first auxiliary electrode so that the first auxiliary electrode is spaced apart from the light emitting layer in a direction parallel to the substrate; forming a cathode electrode and a cathode capping layer on the light emitting layer and the first auxiliary electrode, and forming a plurality of spacers on the cathode capping layer to planarize a level difference between the light emitting layer and the first auxiliary electrode; and forming a second auxiliary electrode on the plurality of spacers and the cathode capping layer, wherein in the forming of the second auxiliary electrode, the second auxiliary electrode is electrically connected to the first auxiliary electrode by the cathode capping layer and the cathode electrode.

The embodiments of the present disclosure have been described hereinabove with reference to the accompanying drawings, but it will be understood by one of ordinary skill in the art to which the present disclosure pertains that various modifications and alterations may be made without departing from the technical spirit or essential feature of the present disclosure. Therefore, it should be understood that the embodiments described above are illustrative in all aspects and not restrictive.

Features of various embodiments of the disclosure may be combined partially or totally. As will be clearly appreciated by those skilled in the art, technically various interactions and operations are possible. Also, various embodiments can be practiced individually or in combination.

In concluding the detailed description, those skilled in the art will appreciate that many variations and modifications can be made to the described embodiments without substantially departing from the spirit and scope of embodiments according to the present disclosure. Therefore, the disclosed embodiments of the invention are used in a generic and descriptive sense and not for purposes of limitation.

## Claims

1. A display device comprising:
a substrate including a light emitting area and a non-light emitting area;
an anode electrode on the light emitting area of the substrate;
a pixel defining layer on the non-light emitting area of the substrate and defining a first opening;
a first auxiliary electrode on the pixel defining layer;
a light emitting layer on the anode electrode and spaced apart from the first auxiliary electrode;
a cathode electrode on the light emitting layer and the first auxiliary electrode;
a cathode capping layer on the cathode electrode;
a spacer on the cathode capping layer and defining a second opening; and
a second auxiliary electrode on the cathode capping layer and the spacer.

2. The display device of claim 1, wherein the spacer includes a first spacer and a second spacer, in a portion overlapping the non-light emitting area, and
the first spacer and the second spacer are spaced apart from each other in a direction parallel to the substrate with the first auxiliary electrode interposed therebetween.

3. The display device of claim 2, wherein the pixel defining layer includes a first surface facing the first auxiliary electrode, and
the first surface includes:
a first portion contacting the first auxiliary electrode;
a second portion contacting the cathode electrode and overlapping the first spacer in a direction perpendicular to the substrate; and
a third portion contacting the cathode electrode and overlapping the second spacer in the direction perpendicular to the substrate.

4. The display device of claim 3, wherein the first portion is between the second portion and the third portion.

5. The display device of claim 4, wherein the first surface further includes a fourth portion contacting the light emitting layer, and
the fourth portion is spaced apart from the first portion.

6. The display device of any one of claims 1 to 5, wherein the first auxiliary electrode is entirely surrounded by the cathode electrode and the pixel defining layer;
optionally wherein the first auxiliary electrode includes a metal with lower resistance than the cathode electrode.

7. The display device of any one of claims 1 to 6, wherein the cathode capping layer contacts the second auxiliary electrode and the spacer, in a portion overlapping the non-light emitting area.

8. The display device of any one of claims 1 to 7, wherein the second auxiliary electrode includes a first portion contacting the cathode capping layer and a second portion in contact with the spacer, in a portion overlapping the non-light emitting area.

9. The display device of claim 8, wherein the second auxiliary electrode is electrically connected to the first auxiliary electrode by the cathode capping layer and the cathode electrode in a portion overlapping the non-light emitting area;
optionally wherein the cathode capping layer and the second auxiliary electrode include transparent conducting oxide.

10. The display device of any one of claims 1 to 9, wherein the spacer is entirely surrounded by the cathode capping layer and the second auxiliary electrode.

11. The display device of any one of claims 1 to 10, wherein the light emitting layer includes a side surface facing the first auxiliary electrode, and an inclination angle formed between the pixel defining layer and the side surface is 60 degrees or more and 90 degrees or less.

12. The display device of any one of claims 1 to 11, wherein the spacer entirely surrounds the first auxiliary electrode in a portion overlapping the non-light emitting area in a plan view.

13. The display device of claim 12, wherein the second auxiliary electrode entirely covers the spacer and the first auxiliary electrode in a portion overlapping the non-light emitting area in the plan view;
optionally wherein the first opening is completely surrounded by the second opening in the plan view.

14. A method of fabricating a display device, the method comprising:
forming an anode electrode on a substrate;
forming a light emitting layer and a sacrificial layer on the anode electrode;
removing a portion of the light emitting layer and the sacrificial layer;
forming a first auxiliary electrode on the sacrificial layer and then removing a portion of the first auxiliary electrode so that the first auxiliary electrode is spaced apart from the light emitting layer in a direction parallel to the substrate;
forming a cathode electrode and a cathode capping layer on the light emitting layer and the first auxiliary electrode, and forming a plurality of spacers on the cathode capping layer to planarize a level difference between the light emitting layer and the first auxiliary electrode; and
forming a second auxiliary electrode on the plurality of spacers and the cathode capping layer,
wherein in the forming of the second auxiliary electrode, the second auxiliary electrode is electrically connected to the first auxiliary electrode by the cathode capping layer and the cathode electrode.

15. The method of claim 14, wherein in the forming of the light emitting layer, the light emitting layer is formed by a photo lithography process;
optionally wherein in the forming of the spacers, the spacer includes hexamethyl disiloxane;
optionally wherein the forming of the first auxiliary electrode includes removing the sacrificial layer and exposing the light emitting layer through an etching process.
